# EUROPEAN PATENT APPLICATION

(11) **EP 4 800 565 A1**
(43) Date of publication of application: **02.09.2026**
(21) Application number: 26160270.0
(22) Date of filing: 24.02.2026
(51) Int. Cl.: G06F 15/78

(54) **SYSTEM AND METHODS FOR DATA COMPRESSION IN LOW POWER DOUBLE DATA RATE-PROCESSING IN MEMORY ON MOBILE SYSTEM ON CHIP**

(30) Priority: 26.02.2025 US 202563763586 P; 16.12.2025 US 202519421187
(71) Applicant: Samsung Electronics Co., Ltd., Suwon-si, Gyeonggi-do 16677 (KR)
(72) Inventor: DUAN, Lide, San Jose, CA 95134 (US); AVADHANAM, Satya, San Jose, CA 95134 (US); GUO, Xiaochen, San Jose, CA 95134 (US); CHA, Kilhyung, San Jose, CA 95134 (US); LAGHARI, Muhammad, San Jose, CA 95134 (US); SCHWEDOCK, Brian Connor, San Jose, CA 95134 (US); QUACH, Nhon Toai, San Jose, CA 95134 (US)
(74) Representative: Kuhnen & Wacker Patent- und Rechtsanwaltsbüro PartG mbB

(57) **Abstract**

A device, system, and method are disclosed for processing-in-memory, PIM, compression. In an embodiment, a method includes obtaining, by an input/output sense amplifier, IOSA (204), from an associated RAM bank (202), compressed data (702); sending, by the IOSA (202), the compressed data (702) divided into a plurality of portions (704); receiving, by a respective decompressor of a plurality of decompressors (306) of a PIM block (212) associated with the RAM bank (202), a respective portion of the compressed data (702); decompressing, by the respective decompressor, the respective portion of the compressed data to obtain a respective portion of decompressed data; and sending, by the respective decompressor, the respective portion of the decompressed data to a respective Arithmetic Logic Unit, ALU, of a plurality of ALUs (308) of the PIM block (212) for processing.

## Description

### TECHNICAL FIELD

The disclosure generally relates to processing in memory (PIM) compression. More particularly, the subject matter disclosed herein relates to utilizing PIM-compression to enable low power double data rate (LPDDR)-PIM on mobile systems on chips (SoCs).

### SUMMARY

Mobile SoCs have a limited memory capacity. Many existing applications already have large memory footprints, such as photo/video editing, gaming, streaming, and mapping / navigation applications. In addition, up to 8 gigabytes (GB) of memory capacity may be reserved for use as a dynamic random access memory (DRAM) cache (often referred to as ZRAM) to improve response time (e.g., app launch time) and user experience, putting further pressure on memory capacity. In addition, mobile large language models (LLMs) have increasingly large model sizes, resulting in large memory footprint, such as 6 to 10 GB.

Accordingly, compression for memory capacity saving is critical to reducing such LLMs' memory footprints. Enabling compression of the model weights, which take up most of the DRAM capacity may be highly desirable since it can reduce the size by 15-40%. However, supporting compression may be challenging in an SoC even without PIM. In addition, as described above, a PIM may be needed to perform efficient matrix-vector multiplication (MVM) on-die (e.g., in memory). Thus, to prevent a memory bottleneck, the PIM may also be required to handle compressed data.

Accordingly, systems and methods are described herein for supporting compression in LPDDR-PIM. More specifically, an efficient method to perform PIM-compression is provided to enable LPDDR-PIM on mobile SoCs. A goal of this design is to provide workable solutions to enable weight compression, preserving general matrix-vector (GEMV) calculation including a partial sum.

Embodiments of the present disclosure provide PIM-compression (weight decompressor inside PIM) architectures using fixed packing architectures, provide row overlapping architectures to reduce the initial data loading penalty, and provide data interleaving architecture to minimize the delay between data loading and calculation.

The disclosed embodiments may provide significant compression savings such as 41% optimal saving using Golomb-Rice (GR) compression, and 36% saving using GR compression with interleaved data storage, as described herein. The disclosed system and methods are also simple to implement, as GR decoders can be utilized with no requirement for tree storage and with simple logic. The disclosed system and methods also provide reduced buffers with smaller uncompressed page size, and have low latency, such as 32 bytes decoded data per cycle, and decoding can start with any fetched compressed data. In addition, the disclosed system and methods are transparent to any variable code length compression scheme, such as Huffman, GR, or the like.

In an embodiment, a method includes obtaining, by an input/output sense amplifier (IOSA) from an associated random access memory (RAM) bank, compressed data; sending, by the IOSA, the compressed data divided into a plurality of portions; receiving, by a respective decompressor of a plurality of decompressors of a PIM block associated with the RAM bank, a respective portion of the compressed data; decompressing, by the respective decompressor, the respective portion of the compressed data to obtain a respective portion of decompressed data; and sending, by the respective decompressor, the respective portion of the decompressed data to a respective Arithmetic Logic Unit (ALU) of a plurality of ALUs of the PIM block for processing.

In an embodiment, a memory device comprises an IOSA associated with a RAM bank and a PIM block, the PIM block comprising a plurality of decompressors and a plurality of ALUs, wherein the memory device is configured to: obtain, by the IOSA from the associated RAM bank, compressed data; send, by the IOSA, the compressed data divided into a plurality of portions; receive, by a respective decompressor of the plurality of decompressors, a respective portion of the compressed data; decompress, by the respective decompressor, the respective portion of the compressed data to obtain a respective portion of decompressed data; and send, by the respective decompressor, the respective portion of the decompressed data to a respective ALU of the plurality of ALUs for processing.

### BRIEF DESCRIPTION OF THE DRAWING

In the following section, the aspects of the subject matter disclosed herein will be described with reference to exemplary embodiments illustrated in the figures, in which:
FIG. 1 is a chart showing the model sizes of LLMs that may be implemented on-device for mobile SoCs and/or PIMs.
FIG. 2 is a block diagram illustrating a DRAM system including a PIM block with decompressors, according to an embodiment.
FIG. 3A is a block diagram illustrating a system for PIM compression, according to an embodiment.
FIG. 3B is a block diagram illustrating information flow in a system for PIM compression, according to an embodiment.
FIG. 4A is a block diagram illustrating a system for PIM compression with fixed size packing, according to an embodiment.
FIG. 4B is a block diagram illustrating information flow in a system for PIM compression with fixed size packing, according to an embodiment.
FIG. 5A is a block diagram illustrating a system for PIM compression with interleaved storage, according to an embodiment.
FIG. 5B is a block diagram illustrating information flow in a system for PIM compression with interleaved storage, according to an embodiment.
FIG. 6A is a timing diagram illustrating timing for PIM compression with fixed size packing, according to an embodiment.
FIG. 6B is a timing diagram illustrating timing for PIM compression with row overlapping in fixed size packing, according to an embodiment.
FIG. 6C is a timing diagram illustrating timing for PIM compression with row overlapping in interleaved storage, according to an embodiment.
FIG. 7A is a communication flow diagram illustrating a method for PIM compression, according to an embodiment.
FIG. 7B is a communication flow diagram illustrating a method for PIM compression with fixed size packing, according to an embodiment.
FIG. 7C is a communication flow diagram illustrating a method for PIM compression with interleaved storage, according to an embodiment.
FIG. 8 is a block diagram of an electronic device in a network environment, according to an embodiment.

### DETAILED DESCRIPTION

In the following detailed description, numerous specific details are set forth in order to provide a thorough understanding of the disclosure. It will be understood, however, by those skilled in the art that the disclosed aspects may be practiced without these specific details. In other instances, well-known methods, procedures, components and circuits have not been described in detail to not obscure the subject matter disclosed herein.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not necessarily all be referring to the same embodiment. Furthermore, the particular features, structures or characteristics may be combined in any suitable manner in one or more embodiments. In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments. Also, depending on the context of discussion herein, a singular term may include the corresponding plural forms and a plural term may include the corresponding singular form. Similarly, a hyphenated term (e.g., "two-dimensional," "pre-determined," "pixel-specific," etc.) may be occasionally interchangeably used with a corresponding non-hyphenated version (e.g., "two dimensional," "predetermined," "pixel specific," etc.), and a capitalized entry (e.g., "Counter Clock," "Row Select," "PIXOUT," etc.) may be interchangeably used with a corresponding non-capitalized version (e.g., "counter clock," "row select," "pixout," etc.). Such occasional interchangeable uses shall not be considered inconsistent with each other.

Also, depending on the context of discussion herein, a singular term may include the corresponding plural forms and a plural term may include the corresponding singular form. It is further noted that various figures (including component diagrams) shown and discussed herein are for illustrative purpose only, and are not drawn to scale. For example, the dimensions of some of the elements may be exaggerated relative to other elements for clarity. Further, if considered appropriate, reference numerals have been repeated among the figures to indicate corresponding and/or analogous elements.

The terminology used herein is for the purpose of describing some example embodiments only and is not intended to be limiting of the claimed subject matter. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly-referenced parts/modules are the only way to implement some of the example embodiments disclosed herein.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein, the term "module" refers to any combination of software, firmware and/or hardware configured to provide the functionality described herein in connection with a module. For example, software may be embodied as a software package, code and/or instruction set or instructions, and the term "hardware," as used in any implementation described herein, may include, for example, singly or in any combination, an assembly, hardwired circuitry, programmable circuitry, state machine circuitry, and/or firmware that stores instructions executed by programmable circuitry. The modules may, collectively or individually, be embodied as circuitry that forms part of a larger system, for example, but not limited to, an integrated circuit (IC), SoC, an assembly, and so forth.

The embodiments of the present disclosure provide PIM-compression (weight decompressor inside PIM) architectures using fixed packing architectures, provide row overlapping architectures to reduce the initial data loading penalty, and provide data interleaving architecture to minimize the delay between data loading and calculation.

Decoder-based LLMs may consist of two types of computation: matrix-matrix multiplication (MMM) and MVM. The former is known to be compute bound (since the amount of computation scales as O(N³) with the size of the matrix) and the latter memory bound. To resolve memory bound problems, a PIM technique may be used, which performs data processing in DRAM, thereby avoiding a DRAM bandwidth (BW) bottleneck.

Mobile SoCs have a limited memory capacity. Many existing applications already have large memory footprints, such as photo/video editing, gaming, streaming, and mapping / navigation applications. In addition, up to 8 gigabytes (GB) of memory capacity may be reserved for use as a DRAM cache (often referred to as ZRAM) to improve response time (e.g., app launch time) and user experience, putting further pressure on memory capacity.

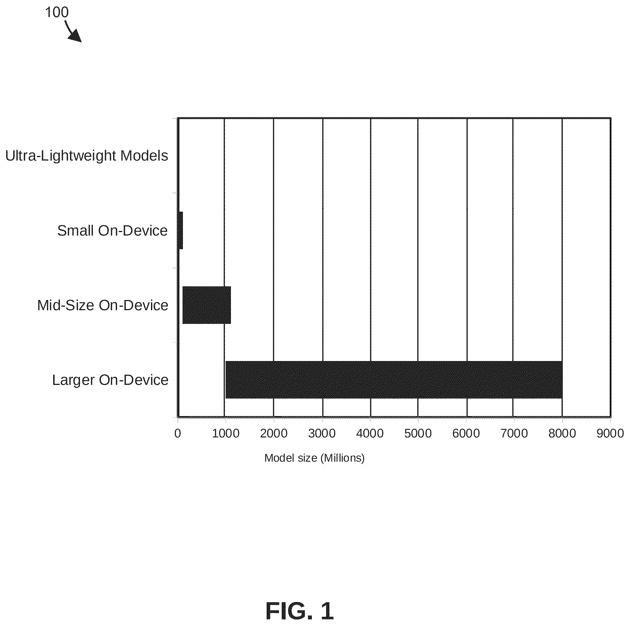

In addition, mobile LLMs have increasingly large model sizes, resulting in large memory footprint, such as 6 to 10 GB. FIG. 1 is a chart showing the model sizes 100 of LLMs that may be implemented on-device for mobile SoCs and/or PIMs. Referring to FIG. 1, ultra lightweight models may require fewer than 10 million symbols (e.g., 10 megabytes (MB)), and may be suited for applications such as auto fill or simple chatbots. Small on-device models may require 10 to 100 million symbols (e.g., 10 to 100 MB), and may be suited for translation. Mid-size on-device models may require 100 million to 1 billion symbols (e.g., 100 MB to 1 GB), and may be suited for on-device assistants. Larger on-device models may require 1 billion to 7 billion symbols (e.g., 1 to 7 GB), and may be suited for edge inference.

Accordingly, compression for memory capacity saving is critical to reducing such LLMs' memory footprints. Enabling compression of the model weights, which take up most of the DRAM capacity may be highly desirable since it can reduce the size by 15-40%. However, supporting compression may be challenging in an SoC even without PIM. In addition, as described above, a PIM may be needed to perform efficient MVM on-die (e.g., in memory). Thus, to prevent a memory bottleneck, the PIM may also be required to handle compressed data.

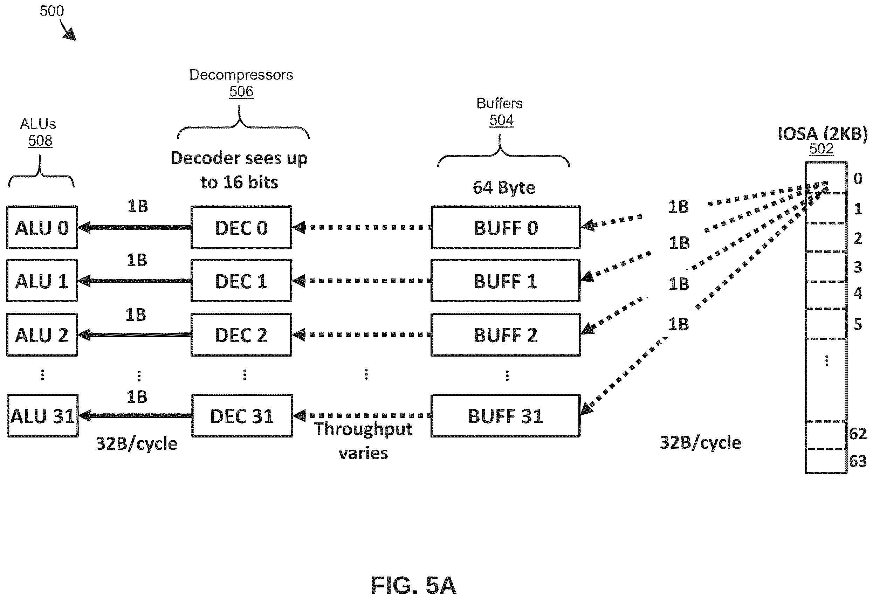

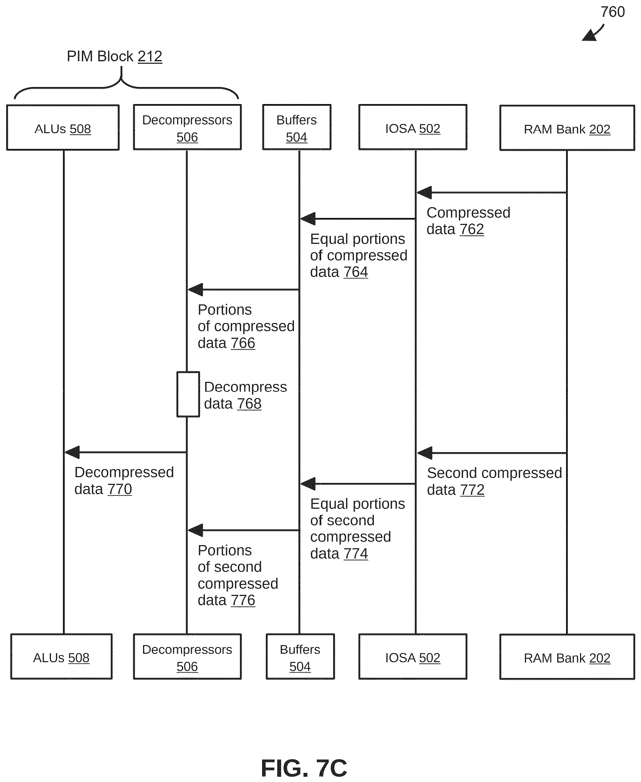

The disclosed embodiments can address this challenge by providing decompressors within a PIM block, thereby decompressing compressed data from an associated RAM bank and/or IOSA, and enabling the PIM block to perform efficient MVMs with compressed data (e.g., for LLMs) in memory. The disclosed embodiments may provide significant compression savings such as 41% optimal saving using GR compression, and 36% saving using GR compression with interleaved data storage, as in the examples of FIGS. 5A-5B and 7C below. The disclosed system and methods are also simple to implement, as GR decoders can be utilized with no requirement for tree storage and with simple logic. The disclosed system and methods also provide reduced buffers with smaller uncompressed page size, and have low latency, such as 32 bytes decoded data per cycle, and decoding can start with any fetched compressed data. In addition, the disclosed system and methods are transparent to any variable code length compression scheme, such as Huffman, Golomb-Rice, or the like.

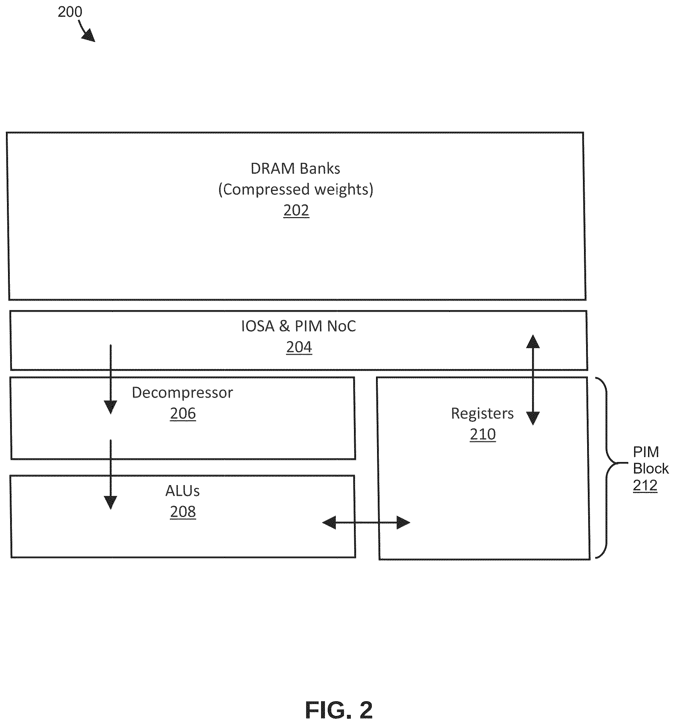

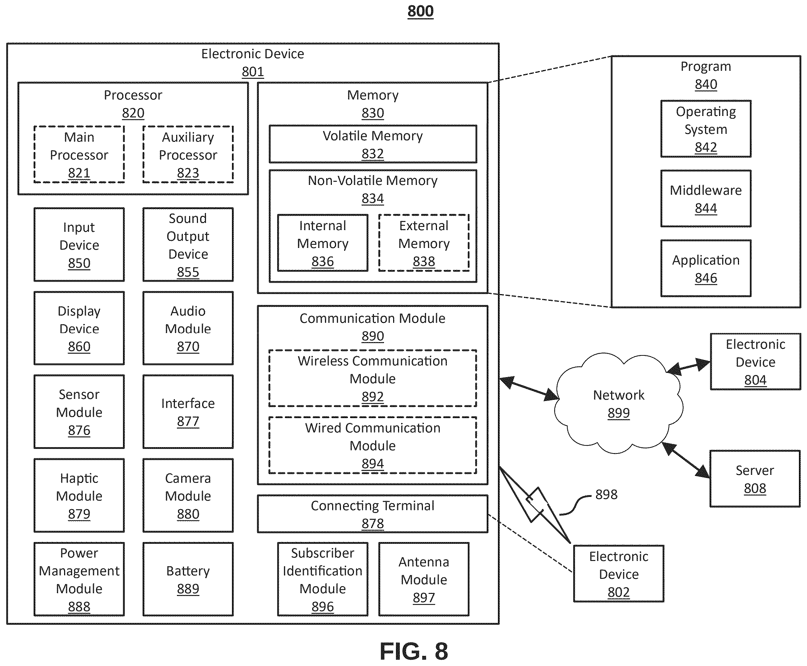

FIG. 2 is a block diagram illustrating a DRAM system 200 including a PIM architecture, such as a PIM block 212 with decompressors 206, according to an embodiment. For example, the DRAM system 200 may be part of a mobile SoC, such as the electronic device 801 of FIG. 8. The DRAM system 200 can include one or more DRAM bank 202, each of which can be associated with a 2 kilobyte (KB) IOSA 204 and a PIM block 212. The PIM block 212, in turn, can include ALUs 208 (also referred to as Multiply and Accumulation Units (MACs)), registers 210, control logic, and decompressors 206, according to embodiments of the present disclosure. As disclosed herein, the decompressors 206 can decompress the contents of the associated DRAM bank 202 and IOSA 204, such that PIM block 212 can process compressed data (e.g., compressed LLMs) in memory.

For example, the system 200 can support MVM using the PIM block 212. A matrix can be partitioned into 2 kilobyte tiles (e.g., the same size as IOSA 204). Each row (also referred to as a stripe) in a tile can be sent to an ALU in parallel with other rows to multiply with an input vector. Enabling weight compression in mobile SoC with PIM: Compression is done by software offline. This is because LLM weights are read only. SW compression can enable flexible weight compression/packing/storage in DRAM. However, decompression can be performed by hardware (e.g., system 200 and/or decompressors 206 added to the PIM block 212) at run time, as disclosed herein.

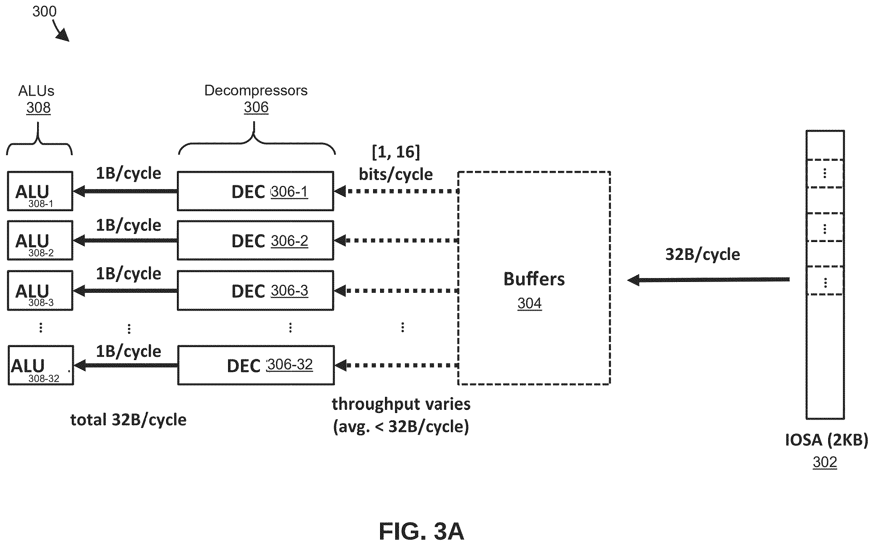

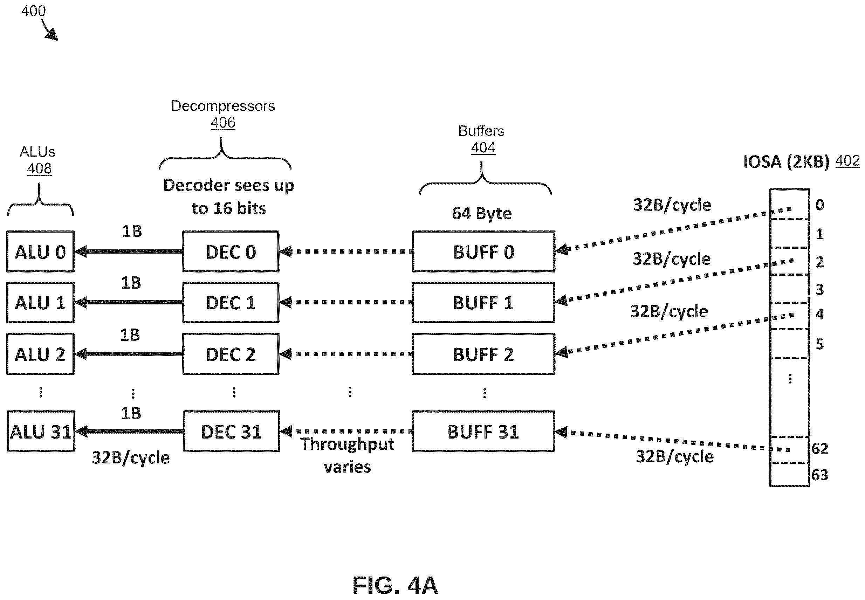

FIG. 3A is a block diagram illustrating a system 300 for PIM compression, according to an embodiment. The system 300 may belong to the DRAM system 200 of FIG. 2 and/or to a mobile SoC or device, such as the electronic device 801 of FIG. 8. Referring to FIG. 3A, the system 300 for PIM compression can include an IOSA 302, buffers 304, decompressors 306 (also referred to herein as decoders), and ALUs 308. As shown, the decompressors 306 may include a plurality of decompressors, such as 32 decompressors 306-1 to 306-32, and the ALUs 308 may include a plurality of ALUs, such as 32 ALUs 308-1 to 308-32. The decompressors 306 may correspond one-to-one to the plurality of ALUs 308. Likewise, in some examples, as illustrated in FIGS. 4A and 5A, the buffers 304 may include a plurality of buffers, such as 32 buffers.

In various embodiments, the system 300 can apply PIM compression using any variable length coding scheme (e.g., Huffman, Golomb-Rice, etc.). For example, each decoded symbol D(x, y) may be 8 bits, while the resulting encoded symbol E(x, y) can vary in length from 1 bit to 16 bits. Although the cumulative compressed size of all symbols can be reduced, the size of an individual symbol may be reduced or expanded under compression. Accordingly, after compression, the respective compressed codes can have variable lengths, which can be 1 bits, 2 bits, or up to 2 bytes. Note that such 1-byte symbol size and 2-byte code size are merely illustrative examples, and the symbol and code size are not limited by the present disclosure. In addition, in some embodiments, the symbol size restrictions may be configurable.

As disclosed herein, the IOSA 302 can obtain compressed data from an associated RAM bank, such as the RAM bank 202 of the example of FIG. 2, and can send the compressed data divided into a plurality of portions to the buffers 304. The portions may be stored and addressed in row-major order, as described in the examples of FIGS. 4A-4B below, or in column-major order, as in the examples of FIGS. 5A-5B below. In an example, the readout throughput of the IOSA 302 may be 32 bytes per cycle, which can include padding. As shown in FIG. 3A, the throughput from buffers 304 to decompressors 306 may vary but average less than 32 bytes per cycle, without the padding, which can be discarded from the buffers 304 before the compressed data is sent to decompressors 306. Because the throughput into buffers 304 can include padding, while the throughput out of buffers 304 does not, the overall throughput may remain balanced. Note that the cycles of the examples of FIGS. 3A-3B, 4A-4B, and 5A-5B may refer to memory controller (MC) cycles.

Each respective decompressor of the decompressors 306 can receive a respective portion of the compressed data from the buffers 304, and can then decompress the respective portion of the compressed data to obtain a portion of decompressed data. In an embodiment, the 32 decompressors 306 may generate 32 decoded symbols, comprising 32 bytes, per cycle to send to the ALUs 308 for processing.

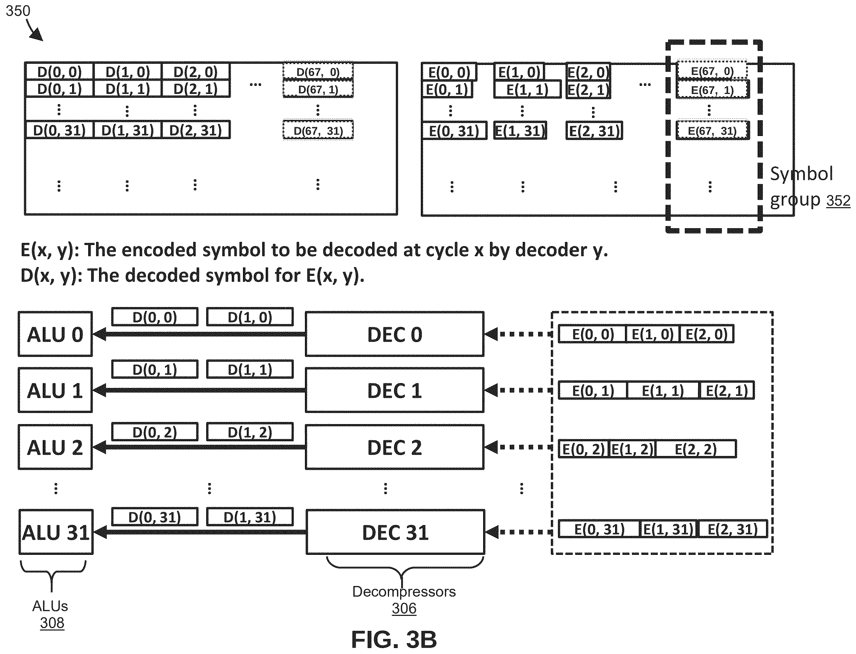

This information flow is illustrated in greater detail in FIG. 3B, which is a block diagram illustrating information flow 350 in the system 300 for PIM compression, according to an embodiment. Referring to FIG. 3B, the E(x, y) can represent an encoded symbol to be decoded during cycle x by decompressor y (e.g., by decompressor 306-y), while the D(x, y) can represent the corresponding decoded symbol for E(x, y). The E(x, y) shown with dashed lines (e.g., E(67, 0) through E(67, 31) in this example) may be decoded in parallel in the same cycle x. This may be referred to as a "symbol group," such as symbol group 352. Accordingly, in an example, each symbol group may comprise a total of 32 encoded symbols, corresponding to a size of 32 bytes after decompression, so that the cycle may proceed in locked-step manner. In various examples, each symbol group may comprise any other number of encoded symbols, and is not limited by the present disclosure.

Accordingly, as shown, 1 decompressed symbol (e.g., 1 byte) D(x, y) can arrive at each ALU 308-y (e.g., 32 decompressed symbols comprising 32 bytes total) of ALUs 308 in each cycle x. The ALUs 308 can then process the decompressed data in locked-step manner. In an embodiment, all 32 decoded symbols may be consumed by the 32 ALUs in a locked-step manner in each cycle.

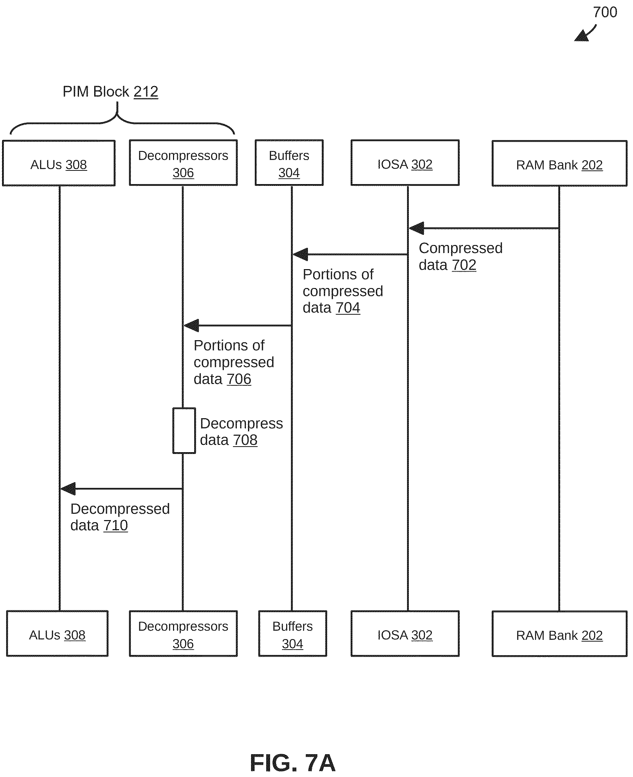

A method for PIM compression according to an embodiment will be described further in the example of FIG. 7A below.

FIG. 4A is a block diagram illustrating a system 400 for PIM compression with fixed size packing, according to an embodiment. The system 400 may be an example of system 300 of FIGS. 3A-3B, wherein as many symbol groups as possible are packed to fit in the IOSA (e.g., a fixed size after packing), and the symbols are compressed, packed, and stored (e.g., addressed) in row-major order. The system 400 may belong to the DRAM system 200 of FIG. 2 and/or to a mobile SoC or device, such as the electronic device 801 of FIG. 8.

Referring to FIG. 4A, the system 400 for PIM compression with fixed size packing can include an IOSA 402, buffers 404, decompressors 406, and ALUs 408. The decompressors 406 may include a plurality of decompressors, such as 32 decompressors 406-1 to 406-32, the ALUs 408 may include a plurality of ALUs, such as 32 ALUs 408-1 to 408-32, and the buffers 404 may include a plurality of buffers, such as 32 buffers 404-1 to 404-32. Each of buffers 404-1 to 404-32 may have a capacity of 64 bytes. Thus, the total size of buffers 404 can be 2 kilobytes, which may be necessary to cover the entire 2 kilobyte capacity of the IOSA. The plurality of buffers 404 may correspond one-to-one to the plurality of decompressors 406 and the plurality of ALUs 408.

As in the example of FIG. 3A, the IOSA 402 can obtain compressed data from an associated RAM bank, such as RAM bank 202 of FIG. 2, and can send the compressed data divided into a plurality of portions to the buffers 404. In this example, the portions can be stored (e.g., addressed) in row-major order. Thus, the data may be organized in rows of the compressed matrix (corresponding to rows of the associated memory bank page and/or the IOSA 402), which may be referred to as stripes. The stripe with the worst compression may determine the number of symbol groups that can be compressed in the IOSA 402, which may have a capacity of 2 kilobytes. For example, the number of compressed symbol groups from each stripe (e.g., in each row) may be equal, so this number may be limited by the stripe having the least efficient compression. In some embodiments, metadata may be utilized to indicate this number of packed symbols in IOSA 402 and to assist with coding. Each stripe can be sent to one decoder and one ALU. The IOSA 402 may send partial stripes in each cycle, for example, a half stripe, which may contain 32 bytes, per cycle.

For example, the IOSA 402 may send a half stripe (e.g., 32 bytes of contiguously addressed compressed data in row-major order) to one of buffers 404 in each cycle, and may continue sending to each buffer sequentially, so that after 64 cycles, one full stripe has been sent to each of buffers 404. For example, in the first 32 cycles, the IOSA 402 may send the first half of each stripe (which may be addressed with an even index as shown, such as IOSA[0], IOSA[2], ... IOSA[62]) to the corresponding buffer (e.g., IOSA[0] to buffer 404-1, IOSA[2] to buffer 404-2, ... IOSA[62] to buffer 404-32). Then, in the next 32 cycles, the IOSA 402 may send the second half of each stripe (which may be addressed with an odd index, such as IOSA[1], IOSA[3], ... IOSA[63]) to the corresponding buffer (e.g., IOSA[1] to buffer 404-1, IOSA[3] to buffer 404-2, ... IOSA[63] to buffer 404-32).

In some examples, the buffers 404 may include 32 buffers, each with 64 byte capacity, and each holding data for one decoder/ALU, thereby providing a total buffer storage of 2 kilobytes, matching the size of IOSA 402. To avoid deadlock between decoders, the total buffer size needs to be at least the size of IOSA 402. To reduce latency, the system can load the 1st 32B of each 64B first, and overlap the computing of the first 32 bytes with the loading of the second 32 bytes. Since each buffer requires data to begin the decompression process, the IOSA 402 may send the first half of each row, followed by the second half in the next cycle. For example, the odd-numbered buffers may be loaded first, followed by even-numbered buffers in the next cycle. In this example, 32 index regions have 64 byte-aligned starting points, e.g., assuming there are 68 packets in 2 kilobytes. Note that the decompression process can only start after the buffers 404 are loaded with data. For the first 32 cycles, the data is absent or insufficient.

Each respective buffer of buffers 404 can send a respective portion of the compressed data to a respective decompressor of the decompressors 406. The size of each compressed symbol E(x, y) can vary, and therefore the throughput of data sent from buffers 404 to decompressors 406 can vary, but on average the throughput may be less than 32 bytes per cycle, without padding, which can be discarded from buffers 404 before the compressed data is sent to decompressors 406. Because the throughput into buffers 404 can include padding, while the throughput out of buffers 404 does not, the overall throughput may remain balanced. In some examples, each of buffers 404 may send one encoded symbol E(x, y) to the corresponding one of decompressors 406 in each cycle, and each of decompressors 406 may send one decoded symbol D(x, y) to the corresponding one of ALUs 408 in each cycle. The overall throughput may remain balanced on average, although the detailed throughput into each individual one of buffers 404 may not balance in each cycle (e.g., each of buffers 404 may receive 32 encoded bytes in one out of 32 cycles, and may send one encoded symbol E(x, y) in each cycle). Each respective decompressor of the decompressors 406 can then decompress its respective portion of the compressed data, to obtain a portion of decompressed data. In an embodiment, the 32 decompressors 306 may generate 32 decoded symbols, comprising 32 bytes, per cycle to send to the ALUs 308 for processing.

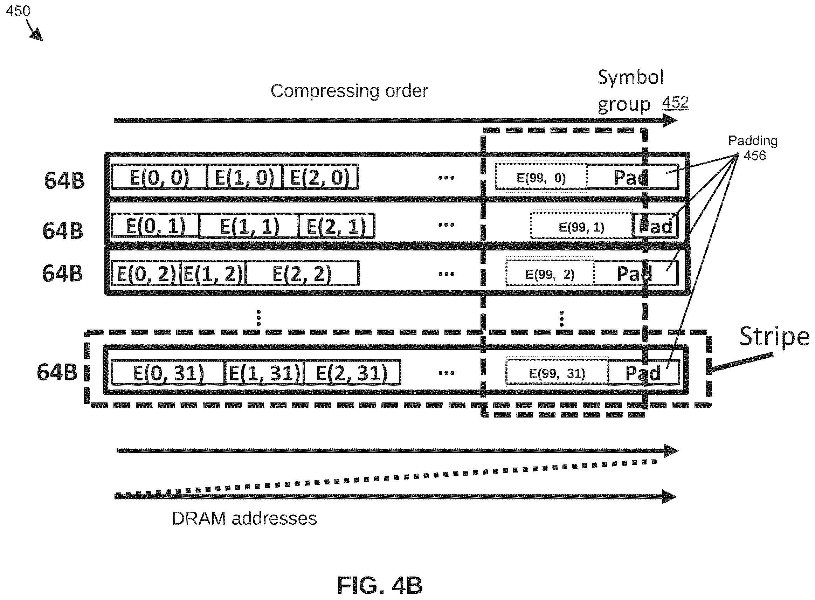

FIG. 4B is a block diagram illustrating information flow in the system 400 for PIM compression with fixed size packing, according to an embodiment.

Referring to FIG. 4B, the symbols may be stored, compressed, and packed in row-major order, as shown. E(x, y) can represent an encoded symbol to be decoded during cycle x by decompressor y (e.g., by decompressor 406-y), while D(x, y) can represent the corresponding decompressed symbol. As in FIG. 3B, the E(x, y) shown with dashed lines (e.g., E(99, 0) through E(99, 1)) may again refer to a symbol group, or a group of encoded symbols to be decoded in parallel during cycle x, such as symbol group 452. Accordingly, each symbol group may comprise a total of 32 encoded symbols, corresponding to a size of 32 bytes after decompression, as well as padding 456 to even out the number of symbols (e.g., decompressed size) of each stripe, so that the cycle x may proceed in locked-step manner. Alternatively, each symbol group may comprise any other number of encoded symbols, and is not limited by the present disclosure.

In this example, the data may be organized in rows of the compressed matrix (corresponding to rows of the associated memory bank page and/or the IOSA 402), which may be referred to as stripes, such as stripe 454. As illustrated, each stripe can comprise multiple encoded symbols E(x, y), so that the entire stripe may be decoded over multiple cycles. Each stripe may require padding 456 only at the end of the stripe (e.g., at the end of each row of the IOSA), as shown. As a result, a relatively small amount of padding is required in the system 400. However, decoding can only start in the system 400 after all 32 buffers are loaded with data.

Accordingly, as shown, 1 decompressed symbol (e.g., 1 byte) D(x, y) can arrive at each ALU 308-y (e.g., 32 decompressed symbols comprising 32 bytes total) of ALUs 308 in each cycle x. The ALUs 308 can then process the decompressed data in locked-step manner. In an embodiment, all 32 decoded symbols may be consumed by the 32 ALUs in a locked-step manner in each cycle.

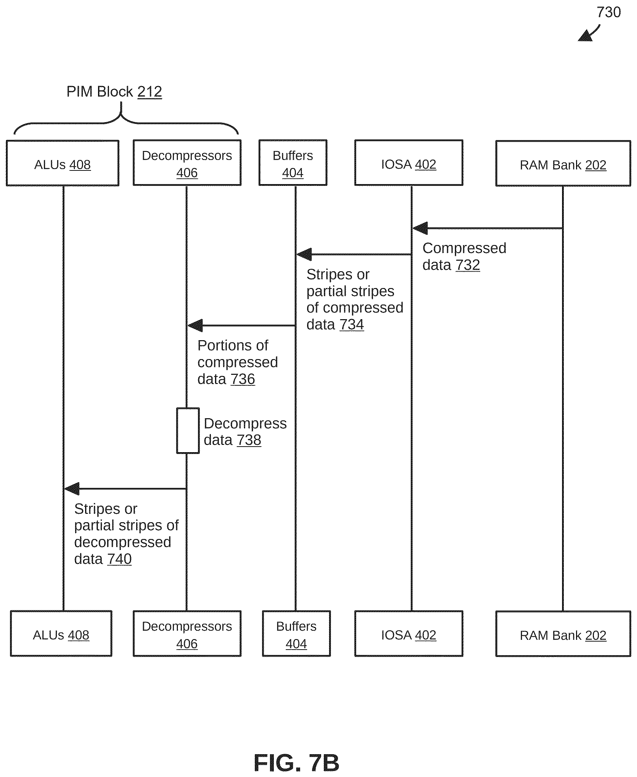

A method for PIM compression with fixed size packing will be described further in the example of FIG. 7B below.

FIG. 5A is a block diagram illustrating a system 500 for PIM compression with interleaved storage, according to an embodiment. The system 500 may be an example of system 300 of FIGS. 3A-3B, wherein symbols are compressed and packed in row-major order, while data storage (e.g., addressing) is in column-major order. The system 500 may belong to the DRAM system 200 of FIG. 2 and/or to a mobile SoC or device, such as the electronic device 801 of FIG. 8.

Referring to FIG. 5A, the system 500 for PIM compression with interleaved data storage can include an IOSA 502, buffers 504, decompressors 506, and ALUs 508. The decompressors 506 may include a plurality of decompressors, such as 32 decompressors 506-1 to 506-32, the ALUs 508 may include a plurality of ALUs, such as 32 ALUs 508-1 to 508-32, and the buffers 504 may include a plurality of buffers, such as 32 buffers 504-1 to 504-32. Each of buffers 504-1 to 504-32 may have a capacity of 64 bytes. Thus, the total size of buffers 504 can be 2 kilobytes, which may be at least the uncompressed page size so as to avoid deadlock between decoders. Note that the uncompressed page size may be 2 kilobytes by default, but can be configurable. The compressed page size can be a multiple of 32 bytes. The plurality of buffers 504 may correspond one-to-one to (e.g., hold data for) the plurality of decompressors 506 and the plurality of ALUs 508. Under the interleaved storage scheme, each 32 bytes can be distributed into all the cycles, while decoding may be performed for each horizontal stripe.

As in the example of FIG. 3A, the IOSA 502 can obtain compressed data from an associated RAM bank, such as RAM bank 202, and can send the compressed data divided into a plurality of portions to the buffers 504. For example, each portion may contain 1 byte (e.g., a packet) of compressed data.

In the example of system 500, the symbols can be compressed and packed in row-major order, while portions can be stored (e.g., addressed) in column-major order. As in the system 400 of FIGS. 4A-4B, the data may be organized in stripes. The IOSA 502 may send partial stripes in each cycle, for example 1 byte per cycle. Each 32 bytes read (e.g., in column-major order) from the IOSA 502 can distribute 1 byte (e.g., a packet) to each of buffers 504, and subsequently to each of decompressors 506.

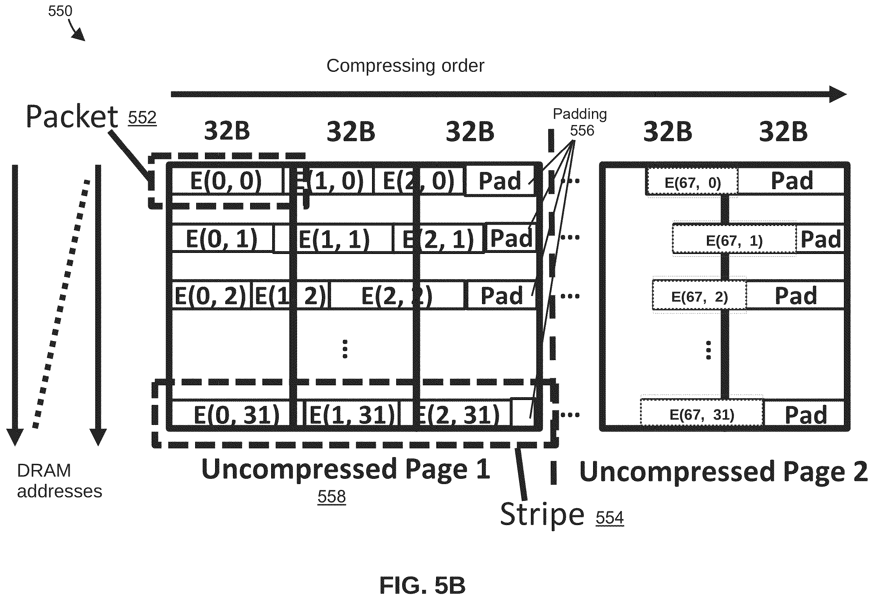

This information flow is illustrated in greater detail in FIG. 5B, which is a block diagram 550 illustrating information flow in the system 500 for PIM compression with interleaved storage, according to an embodiment. Referring to FIG. 5B, the data may be organized in rows (e.g., stripes) of the compressed matrix, such as stripe 554 (corresponding to rows of the associated memory bank pages 558 and 560, and/or the IOSA 502). As shown, the symbols may be addressed in IOSA 502 in column-major order, while the compressing order can be row-major order, e.g., along the stripes. E(x, y) can represent an encoded symbol to be decoded in cycle x by decompressor y (e.g., by decompressor 506-y), while D(x, y) can represent the corresponding decompressed symbol. As illustrated, each packet 552 may contain more or less than one encoded symbol E(x, y), since, as described above, an individual encoded symbol can vary in length from 1 bit to 16 bits. However, since the 32 bytes are read from the IOSA 502 in column-major order, the respective packet sent to each of buffers 504 may belong to a different stripe. In this way, when subsequent packets are sent in subsequent cycles, each respective stripe 554 can eventually be sent to a respective one of decompressors 506 and one of ALUs 508.

For example, as shown in FIGS. 5A and 5B, the 32 packets sent from IOSA 502 (e.g., from IOSA[0]) during the first cycle can include one encoded symbol E(0, y) from each stripe, since the encoded symbols E(0, y) have contiguous DRAM addresses. Likewise, subsequent packets sent from IOSA 502 (e.g., from IOSA[x]) in cycle x can include one encoded symbol E(x, y) from each stripe, since the symbols E(x, y) with fixed x have contiguous DRAM addresses. Accordingly, in cycle x, the IOSA 502 may send the y-th encoded symbol (e.g., E(x, y-1)) to the corresponding buffer 504-y, where y can range from 1 to 32 in an example. In this way, over multiple cycles x, the IOSA 502 can eventually send the entire y-th stripe to the corresponding buffer 504-y.

As in FIGS. 3B and 4B, the E(x, y) shown with dashed lines (e.g., E(67, 0) through E(67, 31)) may again refer to a symbol group. Accordingly, each symbol group may comprise a total of 32 encoded symbols, corresponding to a size of 32 bytes after decompression, as well as padding 556 to even out the number of symbols (e.g., decompressed size) of each stripe, so that the cycle x may proceed in locked-step manner. Alternatively, each symbol group may comprise some other number of encoded symbols, and is not limited by the present disclosure.

The buffers 504 can send the encoded symbols E(x, y) to decompressors 506, which can decode them and send the resulting decoded symbols D(x, y) to ALUs 508 for processing. The throughput from each of buffers 504 to each of decompressors 506 may vary (e.g., from 0 up to 16 bits per cycle), but may average less than 1 byte per cycle from each of buffers 504. For example, padding may be discarded before the compressed data is sent from the buffers 504 to decompressors 506. Because the throughput into buffers 504 can include padding, while the throughput out of buffers 504 does not, the overall throughput may remain balanced.

As illustrated, each stripe 554 can contain multiple encoded symbols E(x, y), so that the entire stripe is decoded over multiple cycles. In this example, the page 558 contains multiple packets arranged horizontally within each stripe, even as the average packet may include more than one encoded symbol and/or may include fractional symbols. Accordingly, each stripe may include padding at the end of each page in order to fill out the page size along the horizontal dimension, such as padding 556 on stripe 554 at the end of page 558.

The system 500 may have the advantages that decoding can start immediately after the first 32 bytes are read from IOSA 502, since each of buffers 504 receives 1 byte, and that no metadata is needed for the number of packed symbols per stripe (implicitly 64). In addition, while system 400 requires the buffer capacity to cover the entire IOSA (e.g., 2 kilobytes), system 500 has flexibility to reduce the buffer size by reducing the uncompressed page size. However, system 500 may require slightly more padding than system 400, which only requires padding at the end of the IOSA. For example, system 500 may require padding at the end of each page, such that reducing the uncompressed page size in order to reduce the required buffer capacity may, in turn, necessitate additional padding.

A method for PIM compression with interleaved data storage will be described further in the example of FIG. 7C below.

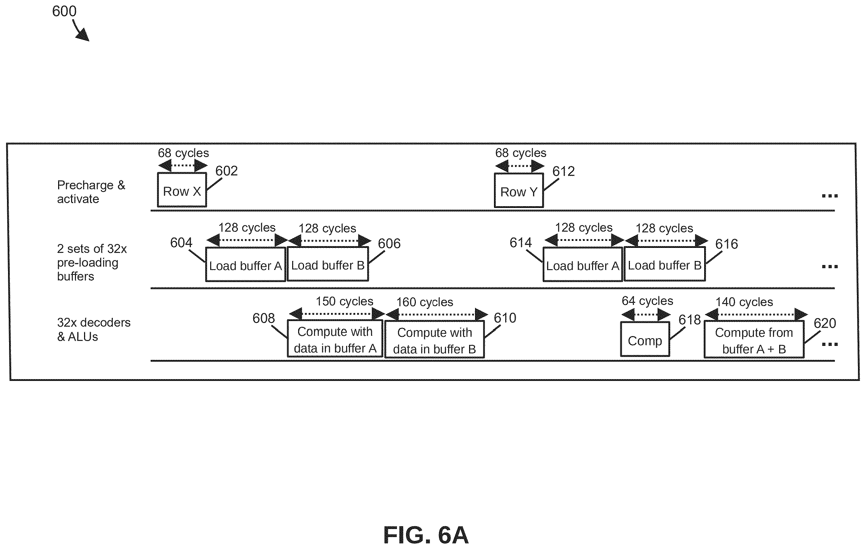

FIG. 6A is a timing diagram illustrating timing in a method 600 for PIM compression with fixed size packing, according to an embodiment. In an example, the method 600 may correspond to the fixed size packing system 400 of FIG. 4A and the fixed size packing method 730 of FIG. 7B. The method 600 can be performed by a RAM bank, such as RAM bank 202 of FIG. 2, and by an IOSA, two sets of pre-loading buffers (e.g., 32 buffers per set), a plurality of decompressors, and a plurality of ALUs, such as IOSA 402, buffers 404, decompressors 406, and ALUs 408 of the fixed size packing system 400 of FIG. 4A. For example, each of the buffers 404 of FIG. 4A may be divided into two parts, of 32 bytes each, which may be referred to as two pre-loading buffers A and B. The cycles of the examples of FIGS. 3A-3B, 4A-4B, and 5A-5B may refer to MC cycles, whereas the examples of FIGS. 6A-6C may refer to DRAM cycles. Note that the DRAM cycles described in this example assume LP5x timing in units of the MC cycle period (e.g., 4 DRAM cycles per 32 bytes loaded). Accordingly, one MC cycle may be equivalent to 4 DRAM cycles (assuming LP5x timing). Also note that the procedure may separate the PIM command for data move and computation, i.e., PIMX_MOV and PIMX_MAC. PIMX_NOP may be used to assure a proper row pre-charge and activation timing as well as the start of computation timing.

Referring to FIG. 6A, first the row X can be precharged and activated at 602. For example, standard DRAM commands can be executed to open a new DRAM row X and copy row X into the IOSA. Precharging and activating the row X may consume 68 DRAM cycles.

Next, the IOSA can load buffer A at 604 and load buffer B at 606. For example, loading buffers A and B may each consume 128 DRAM cycles.

Next, the decompressors and ALUs may compute at 608 with the data in buffer A. For example, buffer A can send the data to the decompressors, which may decompress the data and send it to the ALUs for computation. In an example, the decompressors and ALUs may be 32 in number, and the decompressors may be Huffman decoders. Computing at 608 with the data in buffer A may consume 150 DRAM cycles.

Next, the decompressors and ALUs may compute at 610 with the data in buffer B. For example, buffer B can send the data to the decompressors, which may decompress the data and send it to the ALUs for computation. Computing at 610 with the data in buffer B may consume 160 DRAM cycles.

Next, the row Y can be precharged and activated at 612. For example, standard DRAM commands can be executed to open a new DRAM row Y and copy it into the IOSA. Precharging and activating the row Y may consume 68 DRAM cycles. Note that, in this example, precharging and activating row Y at 612 may occur after the data in both buffers A and B has been computed at 608 and 610, so that loading new data into the buffers will not overlap with computation based on the previous data.

Next, the IOSA can load buffer A at 614 and load buffer B at 616. For example, loading buffers A and B may each consume 128 DRAM cycles.

Next, the decompressors and ALUs may compute at 618 with the data in buffer A. For example, buffer A can send the data to the decompressors, which may decompress the data and send it to the ALUs for computation. Computing at 618 with the data in buffer A may consume 150 DRAM cycles.

Next, the decompressors and ALUs may compute at 620 with the data in buffers A and B. For example, buffers A and B can send the data to the decompressors, which may decompress the data and send it to the ALUs for computation. Computing at 620 with the data in buffers A and B may consume 140 DRAM cycles.

The method 600 may then end.

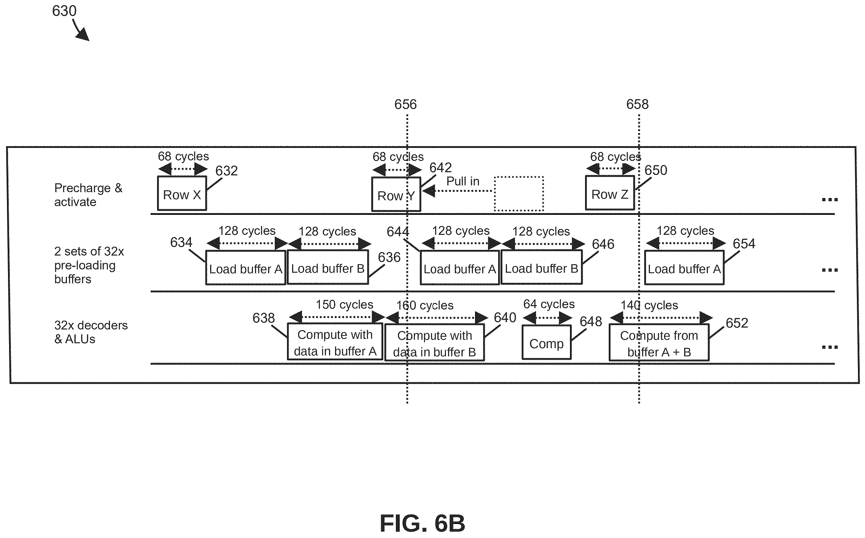

While in the method 600, the row Y may be precharged and activated at 612 after the data in both buffers A and B has been computed at 608 and 610, in some embodiments, it is possible to save computing time by overlapping loading of a new row with computation of an earlier row, which is referred to as row overlapping. For example, row overlapping can involve precharging and activating a subsequent row early to overlap with the computation of the previous row. FIG. 6B is a timing diagram illustrating timing in a method 630 for PIM compression with row overlapping in fixed size packing, according to an embodiment. The method 630 can be performed by a RAM bank, such as RAM bank 202 of FIG. 2, and by an IOSA, two sets of pre-loading buffers (e.g., 32 buffers per set), a plurality of decompressors, and a plurality of ALUs, such as IOSA 402, buffers 404, decompressors 406, and ALUs 408 of the fixed size packing system 400 of FIG. 4A. For example, each of the buffers 404 of FIG. 4A may be divided into two parts, of 32 bytes each, which may be referred to as two pre-loading buffers A and B. In an example, the method 630 may apply row overlapping to the fixed size packing system 400 of FIG. 4A and/or the fixed size packing method 730 of FIG. 7B.

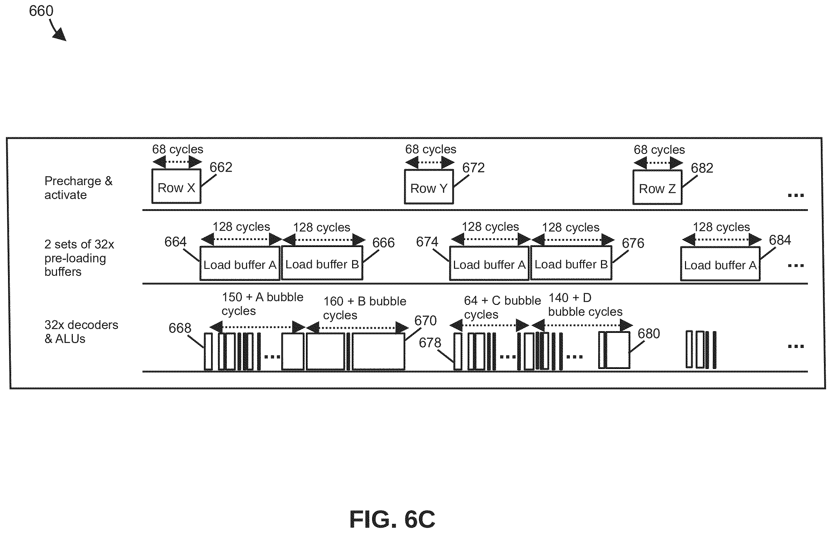

Note that more information may be needed in this example on the memory controller side to insert PIMX_NOP commands before load buffer A and also the first compute chunks, which are not needed in the baseline fixed packing method. To maximize the performance, data interleaving may be performed, as in the example of FIG. 6C below.

Referring to FIG. 6B, first the row X can be precharged and activated at 632. For example, standard DRAM commands can be executed to open a new DRAM row X and copy row X into the IOSA. Precharging and activating the row X may consume 68 DRAM cycles.

Next, the IOSA can load buffer A at 634 and load buffer B at 636. For example, loading buffers A and B may each consume 128 DRAM cycles.

Next, the decompressors and ALUs may compute at 638 with the data in buffer A. For example, buffer A can send the data to the decompressors, which may decompress the data and send it to the ALUs for computation. The decompressors and ALUs may be 32 in number, and the decompressors may be Huffman decoders. Computing at 638 with the data in buffer A may consume 150 DRAM cycles.

Next, the decompressors and ALUs may compute at 640 with the data in buffer B. For example, buffer B can send the data to the decompressors, which may decompress the data and send it to the ALUs for computation. Computing at 640 with the data in buffer B may consume 160 DRAM cycles.

Next, the row Y can be precharged and activated at 642. For example, standard DRAM commands can be executed to open a new DRAM row Y and copy it into the IOSA. Precharging and activating the row Y may consume 68 DRAM cycles. In the example of method 630, precharging and activating row Y at 642 may be pulled in (e.g., performed earlier) compared with method 600 of FIG. 6A. For example, precharging and activating row Y at 642 may overlap (e.g., be performed in parallel) with the data in buffer B being computed at 640, thereby improving the time efficiency of method 630.

Next, the IOSA can load buffer A at 644 and load buffer B at 646. For example, loading buffers A and B may each consume 128 DRAM cycles.

In this example, the line 656 may represent a time at which the computation at 638 with buffer A has completely finished. Accordingly, loading buffer A at 644 may commence after the line 656, such that loading at 644 new data into buffer A will not overlap with the computation at 638 based on the previous data. Moreover, loading buffer B at 646 may commence after computing at 640 with the data in buffer B has completely finished.

However, note that loading at 644 data into buffer A can overlap (e.g., be performed in parallel) with computing at 640 with the data in buffer B, since buffers A and B can be loaded and used independently. Therefore, since precharging and activating row Y at 642, loading buffer A at 644, and subsequent operations can be performed earlier, the method 630 may be more time-efficient than the method 600.

Next, the decompressors and ALUs may compute at 648 with the data in buffer A. For example, buffer A can send the data to the decompressors, which may decompress the data and send it to the ALUs for computation. Computing at 648 with the data in buffer A may consume 64 DRAM cycles.

Next, the row Z can be precharged and activated at 650. For example, standard DRAM commands can be executed to open a new DRAM row Z and copy it into the IOSA. Precharging and activating the row Z may consume 68 DRAM cycles.

In the example of method 630, precharging and activating row Z at 650 may be pulled in (e.g., performed earlier) compared with method 600 of FIG. 6A. For example, precharging and activating row Z is not shown at all in the example of FIG. 6A, because it occurs after the time frame shown there; whereas precharging and activating row Z at 650 is shown in FIG. 6B, because it has been pulled in, thereby improving the time efficiency of method 630.

Next, the decompressors and ALUs may compute at 652 with the data in buffers A and B. Note that the data in buffers A and B may be the data from row Y loaded at operations 644 and 646. While the precharging and activation of row Z at 650 may have already occurred so as to improve the time efficiency of the method 630, the data from row Z may not yet have been loaded into the buffers. Accordingly, in an example, buffers A and B can send the data from row Y to the decompressors, which may decompress the data and send it to the ALUs for computation. Computing at 652 with the data in buffers A and B may consume 140 DRAM cycles.

Next, the IOSA can load buffer A at 654. For example, loading buffer A may consume 128 DRAM cycles. Loading buffer B based on row Z is not shown in this example, however it can follow loading buffer A. Note that loading buffer A based on row Z is not shown at all in the example of FIG. 6A, because it occurs after the time frame shown there; whereas loading row Z at 654 is shown in FIG. 6B, because it has been pulled in, thereby improving the time efficiency of method 630.

Similar to line 656, the line 658 may represent a time at which the computation at 652 with buffer A has completely finished. Accordingly, loading buffer A at 654 may commence after the line 658, such that loading at 654 new data into buffer A will not overlap with the computation at 652 based on the previous data. Note that subsequent to line 658, the computing at 652 with the data in buffers A and B may continue based only on buffer B. Note also that loading buffer B based on row Z (not shown) may commence after computing at 652 with the data in buffers A and B is finished, such that loading new data into buffer B based on row Z will not overlap with the computation at 652 based on the previous data.

The method 630 may then end.

FIG. 6C is a timing diagram illustrating timing in a method 660 for PIM compression with row overlapping in interleaved storage, according to an embodiment. The method 660 can be performed by a RAM bank, such as RAM bank 202 of FIG. 2, and by an IOSA, two sets of pre-loading buffers (e.g., 32 buffers per set), a plurality of decompressors, and a plurality of ALUs, such as IOSA 502, buffers 504, decompressors 506, and ALUs 508 of the fixed size packing system 500 of FIG. 5A. For example, each of the buffers 504 of FIG. 5A may be divided into two parts, of 32 bytes each, which may be referred to as two pre-loading buffers A and B. In an example, the method 660 may apply row overlapping to the interleaved storage system 500 of FIG. 5A and/or the interleaved storage method 760 of FIG. 7C.

Referring to FIG. 6C, first the row X can be precharged and activated at 662. For example, standard DRAM commands can be executed to open a new DRAM row X and copy row X into the IOSA. Precharging and activating the row X may consume 68 DRAM cycles.

Next, the IOSA can load buffer A at 664 and load buffer B at 666. The symbols may be addressed in column-major order. For example, loading buffers A and B may each consume 128 DRAM cycles.

Next, the decompressors and ALUs may compute at 668 with the data in buffer A. For example, buffer A can send the data to the decompressors, which may decompress the data and send it to the ALUs for computation. The decompressors and ALUs may be 32 in number, and the decompressors may be Huffman decoders. Computing at 668 with the data in buffer A may consume 150 DRAM cycles plus a first number of bubble cycles.

Next, the decompressors and ALUs may compute at 670 with the data in buffer B. For example, buffer B can send the data to the decompressors, which may decompress the data and send it to the ALUs for computation. Computing at 670 with the data in buffer B may consume 160 DRAM cycles plus a second number of bubble cycles.

Note that computing at 668 with the data in buffer A may overlap (e.g., be performed in parallel) with loading buffer A at 664, and likewise computing at 670 with the data in buffer B may overlap with loading buffer B at 666. In this example, this is possible because the interleaved data storage scheme of FIGS. 5A-5B and 7C can send individual bytes of compressed data from the IOSA and/or buffers to the decompressors, and can send individual bytes of decompressed data from the decompressors to the ALUs. Accordingly, a row overlapping scheme such as the method 660 can perform overlapping in an even more granular way than the method 630 of FIG. 6B. For example, as illustrated in FIG. 5A, individual bytes can be loaded from the IOSA into the buffers and then decoded and computed in a locked-step manner, even before each buffer is fully loaded.

At 672, the row Y can be precharged and activated. For example, standard DRAM commands can be executed to open a new DRAM row Y and copy it into the IOSA. Precharging and activating the row Y may consume 68 DRAM cycles. In some cases, precharging and activating row Y at 672 can overlap (e.g., be performed in parallel) with computing at 670 with the data in buffer B, thereby improving the time efficiency of the method 660.

At 676, the IOSA can load buffer A at 674 and load buffer B. The symbols may be addressed in column-major order. For example, loading buffers A and B may each consume 128 DRAM cycles.

At 678, the decompressors and ALUs may compute with the data in buffer A. For example, buffer A can send the data to the decompressors, which may decompress the data and send it to the ALUs for computation. Computing at 678 with the data in buffer A may consume 64 DRAM cycles plus a third number of bubble cycles.

At 680, the decompressors and ALUs may compute with the data in buffers A and B. Note that the data in buffers A and B may be the data from row Y loaded at operations 674 and 676. Accordingly, in an example, buffers A and B can send the data from row Y to the decompressors, which may decompress the data and send it to the ALUs for computation. Computing at 680 with the data in buffers A and B may consume 140 DRAM cycles plus a fourth number of bubble cycles.

Note that computing at 678 with the data in buffer A may overlap (e.g., be performed in parallel) with loading buffer A at 674, and likewise computing at 680 with the data in buffers A and B may overlap with loading buffer B at 676. In this example, this is possible because the interleaved data storage scheme of FIGS. 5A-5B and 7C can send individual bytes of compressed data from the IOSA and/or buffers to the decompressors, and can send individual bytes of decompressed data from the decompressors to the ALUs. Accordingly, a row overlapping scheme such as the method 660 can perform overlapping in an even more granular way than the method 630 of FIG. 6B. For example, as illustrated in FIG. 5A, individual bytes can be loaded from the IOSA into the buffers and then decoded and computed in a locked-step manner, even before each buffer is fully loaded.

At 682, the row Z can be precharged and activated. For example, standard DRAM commands can be executed to open a new DRAM row Z and copy it into the IOSA. Precharging and activating the row Z may consume 68 DRAM cycles.

In the example of method 660, precharging and activating row Z at 682 may be performed earlier compared with method 600 of FIG. 6A. For example, precharging and activating row Z is not shown at all in the example of FIG. 6A, whereas precharging and activating row Z at 682 is shown in FIG. 6C, since it is performed earlier, thereby improving the time efficiency of method 660.

At 684, the IOSA can load buffer A based on row Z. The symbols may be addressed in column-major order. For example, loading buffer A may consume 128 DRAM cycles. Loading buffer B based on row Z is not shown in this example, however it can follow loading buffer A. Note that loading buffer A based on row Z is not shown at all in the example of FIG. 6A, whereas loading row Z at 684 is shown in FIG. 6C, since it is performed earlier, thereby improving the time efficiency of method 660.

The method 660 may then end.

FIG. 7A is a communication flow diagram illustrating a method 700 for PIM compression, according to an embodiment. The method 700 may be performed by a RAM bank 202, IOSA 302, buffers 304, and a PIM block 212 including decompressors 306 and ALUs 308, such as those of the examples of FIGS. 2, 3A, 4A, and 5A. In some examples, the buffers 304 may include a plurality of buffers, decompressors 306 may include a plurality of decompressors, and ALUs 308 may include a plurality of ALUs. The buffers 304, decompressors 306, and ALUs 308 may be of the same number and/or may correspond to each other one-to-one, as shown in the examples of FIGS. 4A and 5A. For example, buffers 304 may include 32 buffers, decompressors 306 may include 32 decompressors, and ALUs 308 may include 32 ALUs.

Referring to FIG. 7A, first, the RAM bank 202 can send compressed data 702 to IOSA 302. For example, the RAM bank 202 can use standard DRAM commands, such as precharge and activate, to open one or more new DRAM rows and copy the rows to IOSA 302. The compressed data 702 may be part of a series of transmissions of compressed data, for example it can be preceded by previous transmissions and/or followed by subsequent transmissions. For example, the method 700 may repeat for each transmission in the series and/or may represent a single iteration or cycle within the series. In some examples, the series may be transmitted in a locked-step manner and each transmission of compressed data 702 in the series may contain an equal amount of compressed data 702. In various examples, the compressed data 702 may represent compressed data stored in the RAM bank 202 in row-major (e.g., stripes) and/or column-major order, as described above and in the examples of FIGS. 7B and 7C below.

Next, IOSA 302 can send the compressed data divided into portions 704 to buffers 304.

Next, each respective one of buffers 304 may send a respective portion 706 of the compressed data to a respective decompressor of decompressors 306. In some examples, the throughput (e.g., size) of the respective portion 706 can vary and can differ from the size of the respective portion 704, as shown in the example of FIG. 3A. For example, the respective portion 706 may comprise 1 encoded symbol E(x, y), such that 1 decoded symbol D(x, y) (e.g., 1 byte) can be sent to each respective ALU at a transmission of decompressed data 710.

Next, each respective decompressor of decompressors 306 may decompress at 708 the respective portion 706 of compressed data.

Next, each respective decompressor of decompressors 306 can send the respective portion of decompressed data 710 to a respective ALU of ALUs 308 for processing. In some examples, decompressors 306 may decompress at 708 the portions 704 of compressed data in a locked-step manner and may then send the portions of decompressed data 710 to ALUs 308 for processing in a locked-step manner. The ALUs 308 can then process the respective portions of decompressed data 710.

The method 700 can then repeat as part of a series, as described above, and/or can end.

FIG. 7B is a communication flow diagram illustrating a method 730 for PIM compression with fixed size packing, according to an embodiment. The method 730 may be performed by a RAM bank 202, IOSA 402, buffers 404, and a PIM block 212 including decompressors 406 and ALUs 408, such as those of the examples of FIGS. 2 and 4A. In some examples, the buffers 404 may include a plurality of buffers, decompressors 406 may include a plurality of decompressors, and ALUs 408 may include a plurality of ALUs. The buffers 404, decompressors 406, and ALUs 408 may be of the same number and/or may correspond to each other one-to-one, as shown in the example of FIG. 4A. For example, buffers 404 may include 32 buffers, decompressors 406 may include 32 decompressors, and ALUs 408 may include 32 ALUs.

Referring to FIG. 7B, first, the RAM bank 202 can send compressed data 732 to IOSA 402. For example, the RAM bank 202 can use standard DRAM commands, such as precharge and activate, to open one or more new DRAM rows and copy the rows to IOSA 402. The compressed data 732 may be part of a series of transmissions of compressed data, for example it can be preceded by previous transmissions and/or followed by subsequent transmissions. For example, the method 730 may repeat for each transmission in the series and/or may represent a single iteration or cycle within the series. In some examples, the series may be transmitted in a locked-step manner and each transmission of compressed data 732 in the series may contain an equal amount of compressed data 732. In this example, the compressed data 732 may represent compressed data stored in the RAM bank 202 in row-major (e.g., stripes) order, as described above in the example of FIGS. 4A-4B.

Next, IOSA 402 can send the compressed data divided into stripes or partial stripes 734 to buffers 404. Each stripe may contain sequential compressed data from the RAM bank 202 and/or the IOSA 402, for example compressed data stored and/or addressed in row-major order, as described in the examples of FIGS. 4A-4B. In some examples, the full stripes may contain 64 bytes per stripe of contiguously addressed compressed data in row-major order. In some examples, the partial stripes may be half stripes, for example containing 32 bytes per partial stripe. For example, in the first 32 cycles, the IOSA 402 may send the first half of each stripe (for example, addressed with an even index) to the corresponding buffers. Then, in the next 32 cycles, the IOSA 402 may send the second half of each stripe (for example, addressed with an odd index) to the corresponding buffers. Each stripe or partial stripe 734 may comprise an integer number of compressed symbols E(x, y). Metadata may indicate the total number of compressed symbols in the compressed data.

Next, each respective one of buffers 404 may send a respective portion 736 of the compressed data to a respective decompressor of decompressors 406. In some examples, the throughput (e.g., size) of the respective portion 736 can vary and can differ from the size of the respective stripe or partial stripe 734, as illustrated in the example of FIG. 4A. For example, the respective portion 736 may comprise 1 encoded symbol E(x, y), such that 1 decoded symbol D(x, y) (e.g., 1 byte) can be sent to each respective ALU at transmission of a respective portion 740 of decompressed data.

In some examples, each respective one of buffers 404 may send the respective portion 736 comprising one encoded symbol E(x, y) in each cycle to the corresponding one of decompressors 406. The overall throughput through each of buffers 404 may remain balanced on average, even though its detailed throughput may not balance in each individual cycle. For example, each of buffers 404 may receive a stripe or partial stripe 734 comprising 32 encoded bytes from the IOSA 402 during one out of 32 cycles, and may not receive data during the other 31 cycles. However, in some examples, each of buffers 404 may send the respective portion 736 comprising one encoded symbol E(x, y) in each cycle. The size of the respective portion 736 comprising one encoded symbol E(x, y) may vary, but may be less than 1 byte on average, since the respective portion 736 may not include padding received from IOSA 402. However, each encoded symbol E(x, y) may correspond to 1 symbol (e.g., 1 byte) of decoded data D(x, y).

Next, each respective decompressor of decompressors 406 may decompress at 738 its respective portion 736 of compressed data.

Next, each respective decompressor of decompressors 406 can send the respective portion 740 of decompressed data to a respective ALU of ALUs 408 for processing. In some examples, decompressors 406 may decompress at 738 the portions 736 of compressed data in a locked-step manner and may then send the portions 740 of decompressed data to ALUs 408 for processing in a locked-step manner. In some examples, each respective one of decompressors 406 may send the respective portion 740 comprising one decoded symbol D(x, y) to the corresponding one of ALUs 408 in each cycle. The ALUs 408 can then process the respective portions 740 of decompressed data.

The method 730 can then repeat as part of a series, as described above, and/or can end.

FIG. 7C is a communication flow diagram illustrating a method 760 for PIM compression with interleaved storage, according to an embodiment. The method 760 may be performed by a RAM bank 202, IOSA 502, buffers 504, and a PIM block 212 including decompressors 506 and ALUs 508, such as those of the examples of FIGS. 2 and 5A. In some examples, the buffers 504 may include a plurality of buffers, decompressors 506 may include a plurality of decompressors, and ALUs 508 may include a plurality of ALUs. The buffers 504, decompressors 506, and ALUs 508 may be of the same number and/or may correspond to each other one-to-one, as shown in the example of FIG. 5A. For example, buffers 504 may include 32 buffers, decompressors 506 may include 32 decompressors, and ALUs 508 may include 32 ALUs.

Referring to FIG. 7C, first, the RAM bank 202 can send compressed data 762 to IOSA 502. For example, the RAM bank 202 can use standard DRAM commands, such as precharge and activate, to open one or more new DRAM rows and copy the rows to IOSA 502. The compressed data 762 may be part of a series of transmissions of compressed data, for example it can be preceded by previous transmissions and/or followed by subsequent transmissions. For example, the method 760 may repeat for each transmission in the series and/or may represent one or more iteration or cycle within the series. In some examples, the series may be transmitted in a locked-step manner and each transmission 762 in the series may contain an equal amount of compressed data 762. In this example, the compressed data 762 may represent compressed data stored in the RAM bank 202 in column-major order, while the symbols may be compressed and packed in row-major order, as described above in the example of FIGS. 5A-5B.

Next, IOSA 502 can send the compressed data divided into equal portions 764 to buffers 504. For example, the equal portions 764 may contain 1 byte of compressed data each, as shown in the example of FIG. 5A. For example, the equal portions 764 sent from IOSA 502 during the first cycle can include one packet (e.g., one encoded symbol E(0, y)) from each stripe, since the encoded symbols E(0, y) may have contiguous DRAM addresses. Likewise, equal portions 764 sent during cycle x can include one packet (e.g., one encoded symbol E(x, y)) from each stripe, since the symbols E(x, y) with fixed x can have contiguous DRAM addresses. Accordingly, in cycle x, the IOSA 502 may send each one of equal portions 764 (e.g., each packet) to the corresponding one of buffers 504. In this way, over multiple cycles x, the IOSA 502 can eventually send each respective stripe to the corresponding one of buffers 504.

Next, each respective one of buffers 504 may send a respective portion 766 of the compressed data to a respective decompressor of decompressors 506. The throughput (e.g., size) of the respective portion 766 may vary (e.g., from 0 to 16 bits per cycle), as shown in the example of FIG. 5A. For example, the respective portion 766 may comprise 1 encoded symbol E(x, y), such that 1 decoded symbol D(x, y) (e.g., 1 byte of decompressed data) can be sent to each respective ALU at 770. However, the throughput (e.g., size) of the respective portion 766 may average less than 1 byte per cycle. For example, padding present in each respective one of equal portions 764 may be discarded, and thus may not be included in the respective portion 766. In this way, the overall throughput of respective portion 766 may balance the throughput of equal portions 764.

Next, each respective decompressor of decompressors 506 may decompress at 768 the respective portion 766 of compressed data.

Next, each respective decompressor of decompressors 506 can send the respective portion 770 of decompressed data to a respective ALU of ALUs 508 for processing. In some examples, decompressors 506 may decompress at 768 the portions 766 of compressed data in a locked-step manner and may then send the portions 770 of decompressed data to ALUs 508 for processing in a locked-step manner. The ALUs 508 can then process the respective portions 770 of decompressed data.

Next, the RAM bank 202 can send second compressed data 772 to IOSA 502. For example, the RAM bank 202 can again use standard DRAM commands, such as precharge and activate, to open one or more new DRAM rows and copy the rows to IOSA 502. As described in the example of FIG. 6C, in some cases sending second compressed data 772 to IOSA 502 may overlap (e.g., be performed in parallel) with sending the respective portion 770 of decompressed data to a respective ALU and/or with processing the respective portion 770 by the ALU. Accordingly, the time efficiency of the method 760 may be improved by such a row overlapping scheme.

The second compressed data 772 may be part of a series of transmissions of compressed data, for example it can be preceded by the previous transmission of compressed data 762, and/or be followed by subsequent transmissions. For example, the method 760 may repeat for each transmission in the series and/or may represent one or more iteration or cycle within the series. In some examples, the series may be transmitted in a locked-step manner and each transmission 762 and 772 in the series may contain an equal amount of compressed data. In this example, the second compressed data 772 may represent compressed data stored in the RAM bank 202 in column-major order, while the symbols may be compressed and packed in row-major order.

Next, IOSA 502 can send the second compressed data divided into equal portions 774 to buffers 504. For example, the equal portions 774 may contain 1 byte of compressed data each, as in the example of FIG. 5A.

Next, each respective one of buffers 504 may send a respective portion 776 of the second compressed data to a respective decompressor of decompressors 506. The throughput (e.g., size) of the respective portion 776 may vary, as in the example of FIG. 5A. For example, the respective portion 776 may comprise 1 encoded symbol E(x, y), such that 1 decoded symbol D(x, y) (e.g., 1 byte of decompressed data) can subsequently be sent to each respective ALU.

After the second compressed data is decompressed and sent to the ALUs 508 for processing (not shown), the method 760 can then repeat as part of a series, as described above, and/or can end.

The disclosed embodiments may provide significant compression savings such as 41% optimal saving using GR compression, and 36% saving using GR compression with interleaved data storage, as in the examples of FIGS. 5A-5B and 7C. The disclosed system and methods are also simple to implement, as GR decoders can be utilized with no requirement for tree storage and with simple logic. The disclosed system and methods also provide reduced buffers with smaller uncompressed page size, and have low latency, such as 32 bytes decoded data per cycle, and decoding can start with any fetched compressed data. In addition, the disclosed system and methods are transparent to any variable code length compression scheme, such as Huffman, GR, or the like.

FIG. 8 is a block diagram of an electronic device 801 in a network environment 800, according to an embodiment. For example, the electronic device may include a mobile SoC or other device, such as the DRAM system 200 of FIG. 2, the system 300 for PIM compression of FIG. 3A, system 400 for PIM compression with fixed size packing of FIG. 4A, and/or sys system 500 for PIM compression with interleaved storage of FIG. 5A.

Referring to FIG. 8, an electronic device 801 in a network environment 800 may communicate with an electronic device 802 via a first network 898 (e.g., a short-range wireless communication network), or an electronic device 804 or a server 808 via a second network 899 (e.g., a long-range wireless communication network). The electronic device 801 may communicate with the electronic device 804 via the server 808. The electronic device 801 may include a processor 820, a memory 830, an input device 850, a sound output device 855, a display device 860, an audio module 870, a sensor module 876, an interface 877, a haptic module 879, a camera module 880, a power management module 888, a battery 889, a communication module 890, a subscriber identification module (SIM) card 896, or an antenna module 897. In one embodiment, at least one (e.g., the display device 860 or the camera module 880) of the components may be omitted from the electronic device 801, or one or more other components may be added to the electronic device 801. Some of the components may be implemented as a single integrated circuit (IC). For example, the sensor module 876 (e.g., a fingerprint sensor, an iris sensor, or an illuminance sensor) may be embedded in the display device 860 (e.g., a display).

The processor 820 may execute software (e.g., a program 840) to control at least one other component (e.g., a hardware or a software component) of the electronic device 801 coupled with the processor 820 and may perform various data processing or computations.

As at least part of the data processing or computations, the processor 820 may load a command or data received from another component (e.g., the sensor module 876 or the communication module 890) in volatile memory 832, process the command or the data stored in the volatile memory 832, and store resulting data in non-volatile memory 834. The processor 820 may include a main processor 821 (e.g., a central processing unit (CPU) or an application processor (AP)), and an auxiliary processor 823 (e.g., a graphics processing unit (GPU), an image signal processor (ISP), a sensor hub processor, or a communication processor (CP)) that is operable independently from, or in conjunction with, the main processor 821. Additionally or alternatively, the auxiliary processor 823 may be adapted to consume less power than the main processor 821, or execute a particular function. The auxiliary processor 823 may be implemented as being separate from, or a part of, the main processor 821.

The auxiliary processor 823 may control at least some of the functions or states related to at least one component (e.g., the display device 860, the sensor module 876, or the communication module 890) among the components of the electronic device 801, instead of the main processor 821 while the main processor 821 is in an inactive (e.g., sleep) state, or together with the main processor 821 while the main processor 821 is in an active state (e.g., executing an application). The auxiliary processor 823 (e.g., an image signal processor or a communication processor) may be implemented as part of another component (e.g., the camera module 880 or the communication module 890) functionally related to the auxiliary processor 823.

The memory 830 may store various data used by at least one component (e.g., the processor 820 or the sensor module 876) of the electronic device 801. The various data may include, for example, software (e.g., the program 840) and input data or output data for a command related thereto. The memory 830 may include the volatile memory 832 or the non-volatile memory 834. Non-volatile memory 834 may include internal memory 836 and/or external memory 838.

The program 840 may be stored in the memory 830 as software, and may include, for example, an operating system (OS) 842, middleware 844, or an application 846.

The input device 850 may receive a command or data to be used by another component (e.g., the processor 820) of the electronic device 801, from the outside (e.g., a user) of the electronic device 801. The input device 850 may include, for example, a microphone, a mouse, or a keyboard.

The sound output device 855 may output sound signals to the outside of the electronic device 801. The sound output device 855 may include, for example, a speaker or a receiver. The speaker may be used for general purposes, such as playing multimedia or recording, and the receiver may be used for receiving an incoming call. The receiver may be implemented as being separate from, or a part of, the speaker.

The display device 860 may visually provide information to the outside (e.g., a user) of the electronic device 801. The display device 860 may include, for example, a display, a hologram device, or a projector and control circuitry to control a corresponding one of the display, hologram device, and projector. The display device 860 may include touch circuitry adapted to detect a touch, or sensor circuitry (e.g., a pressure sensor) adapted to measure the intensity of force incurred by the touch.

The audio module 870 may convert a sound into an electrical signal and vice versa. The audio module 870 may obtain the sound via the input device 850 or output the sound via the sound output device 855 or a headphone of an external electronic device 802 directly (e.g., wired) or wirelessly coupled with the electronic device 801.

The sensor module 876 may detect an operational state (e.g., power or temperature) of the electronic device 801 or an environmental state (e.g., a state of a user) external to the electronic device 801, and then generate an electrical signal or data value corresponding to the detected state. The sensor module 876 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 877 may support one or more specified protocols to be used for the electronic device 801 to be coupled with the external electronic device 802 directly (e.g., wired) or wirelessly. The interface 877 may include, for example, a high- definition multimedia interface (HDMI), a universal serial bus (USB) interface, a secure digital (SD) card interface, or an audio interface.

A connecting terminal 878 may include a connector via which the electronic device 801 may be physically connected with the external electronic device 802. The connecting terminal 878 may include, for example, an HDMI connector, a USB connector, an SD card connector, or an audio connector (e.g., a headphone connector).

The haptic module 879 may convert an electrical signal into a mechanical stimulus (e.g., a vibration or a movement) or an electrical stimulus which may be recognized by a user via tactile sensation or kinesthetic sensation. The haptic module 879 may include, for example, a motor, a piezoelectric element, or an electrical stimulator.

The camera module 880 may capture a still image or moving images. The camera module 880 may include one or more lenses, image sensors, image signal processors, or flashes. The power management module 888 may manage power supplied to the electronic device 801. The power management module 888 may be implemented as at least part of, for example, a power management integrated circuit (PMIC).

The battery 889 may supply power to at least one component of the electronic device 801. The battery 889 may include, for example, a primary cell which is not rechargeable, a secondary cell which is rechargeable, or a fuel cell.

The communication module 890 may support establishing a direct (e.g., wired) communication channel or a wireless communication channel between the electronic device 801 and the external electronic device (e.g., the electronic device 802, the electronic device 804, or the server 808) and performing communication via the established communication channel. The communication module 890 may include one or more communication processors that are operable independently from the processor 820 (e.g., the AP) and supports a direct (e.g., wired) communication or a wireless communication. The communication module 890 may include a wireless communication module 892 (e.g., a cellular communication module, a short-range wireless communication module, or a global navigation satellite system (GNSS) communication module) or a wired communication module 894 (e.g., a local area network (LAN) communication module or a power line communication (PLC) module). A corresponding one of these communication modules may communicate with the external electronic device via the first network 898 (e.g., a short-range communication network, such as BLUETOOTH^{™}, wireless-fidelity (Wi-Fi) direct, or a standard of the Infrared Data Association (IrDA)) or the second network 899 (e.g., a long-range communication network, such as a cellular network, the Internet, or a computer network (e.g., LAN or wide area network (WAN)). These various types of communication modules may be implemented as a single component (e.g., a single IC), or may be implemented as multiple components (e.g., multiple ICs) that are separate from each other. The wireless communication module 892 may identify and authenticate the electronic device 801 in a communication network, such as the first network 898 or the second network 899, using subscriber information (e.g., international mobile subscriber identity (IMSI)) stored in the subscriber identification module 896.

The antenna module 897 may transmit or receive a signal or power to or from the outside (e.g., the external electronic device) of the electronic device 801. The antenna module 897 may include one or more antennas, and, therefrom, at least one antenna appropriate for a communication scheme used in the communication network, such as the first network 898 or the second network 899, may be selected, for example, by the communication module 890 (e.g., the wireless communication module 892). The signal or the power may then be transmitted or received between the communication module 890 and the external electronic device via the selected at least one antenna.

Commands or data may be transmitted or received between the electronic device 801 and the external electronic device 804 via the server 808 coupled with the second network 899. Each of the electronic devices 802 and 804 may be a device of a same type as, or a different type, from the electronic device 801. All or some of operations to be executed at the electronic device 801 may be executed at one or more of the external electronic devices 802, 804, or 808. For example, if the electronic device 801 should perform a function or a service automatically, or in response to a request from a user or another device, the electronic device 801, instead of, or in addition to, executing the function or the service, may request the one or more external electronic devices to perform at least part of the function or the service. The one or more external electronic devices receiving the request may perform the at least part of the function or the service requested, or an additional function or an additional service related to the request and transfer an outcome of the performing to the electronic device 801. The electronic device 801 may provide the outcome, with or without further processing of the outcome, as at least part of a reply to the request. To that end, a cloud computing, distributed computing, or client-server computing technology may be used, for example.

Embodiments of the subject matter and the operations described in this specification may be implemented in digital electronic circuitry, or in computer software, firmware, or hardware, including the structures disclosed in this specification and their structural equivalents, or in combinations of one or more of them. Embodiments of the subject matter described in this specification may be implemented as one or more computer programs, i.e., one or more modules of computer-program instructions, encoded on computer-storage medium for execution by, or to control the operation of data-processing apparatus. Alternatively or additionally, the program instructions can be encoded on an artificially-generated propagated signal, e.g., a machine-generated electrical, optical, or electromagnetic signal, which is generated to encode information for transmission to suitable receiver apparatus for execution by a data processing apparatus. A computer-storage medium can be, or be included in, a computer-readable storage device, a computer-readable storage substrate, a random or serial-access memory array or device, or a combination thereof. Moreover, while a computer-storage medium is not a propagated signal, a computer-storage medium may be a source or destination of computer-program instructions encoded in an artificially-generated propagated signal. The computer-storage medium can also be, or be included in, one or more separate physical components or media (e.g., multiple CDs, disks, or other storage devices). Additionally, the operations described in this specification may be implemented as operations performed by a data-processing apparatus on data stored on one or more computer-readable storage devices or received from other sources.

While this specification may contain many specific implementation details, the implementation details should not be construed as limitations on the scope of any claimed subject matter, but rather be construed as descriptions of features specific to particular embodiments. Certain features that are described in this specification in the context of separate embodiments may also be implemented in combination in a single embodiment. Conversely, various features that are described in the context of a single embodiment may also be implemented in multiple embodiments separately or in any suitable subcombination. Moreover, although features may be described above as acting in certain combinations and even initially claimed as such, one or more features from a claimed combination may in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described herein. Other embodiments are within the scope of the following claims. In some cases, the actions set forth in the claims may be performed in a different order and still achieve desirable results. Additionally, the processes depicted in the accompanying figures do not necessarily require the particular order shown, or sequential order, to achieve desirable results. In certain implementations, multitasking and parallel processing may be advantageous.

## Claims

1. A processing-in-memory, PIM, compression method, comprising:
obtaining, by an input/output sense amplifier, IOSA (204, 402, 502), from an associated random access memory, RAM, bank (202), compressed data (702, 732, 762);
sending, by the IOSA (204, 302, 402, 502), the compressed data (702, 732, 762) divided into a plurality of portions (704, 734, 764);
receiving, by a respective decompressor of a plurality of decompressors (206, 306, 406, 506) of a PIM block (212) associated with the RAM bank (202), a respective portion of the compressed data;
decompressing, by the respective decompressor, the respective portion of the compressed data to obtain a respective portion of decompressed data; and
sending, by the respective decompressor, the respective portion of the decompressed data to a respective Arithmetic Logic Unit, ALU, of a plurality of ALUs (208, 308, 408, 508) of the PIM block (212) for processing.

2. The PIM compression method of claim 1, wherein:
sending, by the IOSA (204, 302, 402, 502), the compressed data (702, 732, 762) comprises sending, by the IOSA (204, 302, 402, 502), the compressed data (702, 732, 762) to one or more buffer (304, 404, 504); and
receiving, by the respective decompressor, the respective portion of the compressed data comprises receiving, by the respective decompressor and from the one or more buffer (304, 404, 504), the respective portion of the compressed data (702, 732, 762).

3. The PIM compression method of claim 1 or 2, wherein:
the plurality of portions of the compressed data comprises a plurality of stripes (734) of the compressed data;
a respective stripe of the plurality of stripes (734) comprises sequential compressed data; and
decompressing, by the respective decompressor, the respective portion of the compressed data comprises decompressing, by the respective decompressor, the respective stripe or a partial stripe of the respective stripe.

4. The PIM compression method of claim 3, wherein the partial stripe comprises half of the respective stripe of the plurality of stripes (734).

5. The PIM compression method of claim 3 or4, wherein:
the respective stripe of the plurality of stripes comprises 32 or 64 bytes; and/or
the partial stripe comprises 32 bytes.

6. The PIM compression method of any one of claims 3 to 5, wherein:
the respective stripe comprises a respective integer number of compressed symbols; and
metadata indicates a total number of compressed symbols in the compressed data.

7. The PIM compression method of any one of claims 1 to 6:
wherein each of the plurality of portions (764) of the compressed data comprises an equal number of bytes;
wherein decompressing, by the respective decompressor, the respective portion of the compressed data comprises decompressing, by the respective decompressor, the equal number of bytes; and
further comprising receiving, by the respective decompressor after sending the respective portion of the decompressed data to the respective ALU, a respective portion of second compressed data.

8. The PIM compression method of claim 7, wherein the equal number of bytes comprises one byte.

9. The PIM compression method of claim 7 or 8, wherein adjacent portions of the plurality of portions (764) of the compressed data comprise sequential compressed data, and the respective portion of second compressed data comprises the equal number of bytes.

10. The PIM compression method of any one of claims 7 to 9, wherein the respective portion of the compressed data and the respective portion of the second compressed data belong to a single respective stripe of the compressed data.

11. The PIM compression method of any one of claims 1 to 10, wherein the plurality of decompressors (206, 306, 406, 506) comprises 32 decompressors (206, 306, 406, 506), the plurality of portions (704, 734, 764) of the compressed data comprises 32 portions of the compressed data, and the plurality of ALUs (208, 308, 408, 508) comprises 32 ALUs.

12. The PIM compression method of any one of claims 1 to 11, further comprising, while the respective decompressor decompresses the respective portion of the compressed data, obtaining, by the IOSA (204, 302, 402, 502) from the associated RAM bank, next compressed data.

13. A memory device comprising an input/output sense amplifier, IOSA (204, 302, 402, 502), associated with a random access memory, RAM, bank and a processing-in-memory, PIM, block (212), the PIM block (212) comprising a plurality of decompressors (206, 306, 406, 506) and a plurality of Arithmetic Logic Units, ALUs (208, 308, 408, 508), the memory device configured to perform the PIM compression method of any one of the preceding claims.
